# EUROPEAN PATENT APPLICATION

(11) **EP 0 707 097 A1**
(43) Date of publication of application: **17.04.1996**
(21) Application number: 95116058.9
(22) Date of filing: 11.10.1995
(51) Int. Cl.: C30B 23/06

(54) **MBE apparatus and MBE method**

(30) Priority: 14.10.1994 JP 249546/94; 18.09.1995 JP 238341/95
(71) Applicant: MITSUBISHI DENKI KABUSHIKI KAISHA, Tokyo 100 (JP)
(72) Inventor: Hayafuji, Norio, c/o Mitsubishi Denki K. K., Tokyo 100 (JP); Izumi, Shigekazu, c/o Mitsubishi Denki K. K., Tokyo 100 (JP); Kadoiwa, Kaoru, c/o Mitsubishi Denki K. K., Tokyo 100 (JP); Uneme, Yutaka, c/o Mitsubishi Denki K. K., Tokyo 100 (JP)
(74) Representative: KUHNEN, WACKER & PARTNER

(57) **Abstract**

An MBE apparatus includes a heatable crucible (4) containing crystal material (3) which becomes a molecular beam state by heating, a different kind of gas introducing capillary (7) for introducing different kind of gas other than material gas for the crystal growth into the crucible (4), and a crystal growth chamber in which the crystal growth is performed because the crystal material (3) in the molecular beam state emitted from the crucible (4) is irradiated to the substrate. An MBE method comprises heating the crucible (4) containing the material (3) which becomes the molecular beam state by heating while a gas having reducibility is introduced into the crucible (4) through the different kind of gas introducing capillary (7), and irradiating the molecular beam of the crystal material (3) to the substrate in the crystal growth chamber while the impurities of oxidized nature in the crystal growth material in the molecular beam state in the crucible (4) are collected by the gas. Therefore, defects on the substrate surface caused by impurities of oxidized nature are effectively reduced.

## Description

### FIELD OF THE INVENTION

The present invention relates to a molecular beam epitaxy (MBE) apparatus which is mainly used as a material for a semiconductor laser and a device material for an extra high frequency and an MBE method. More particularly, this invention relates to an apparatus and a method for growing a III-V group compound semiconductor with high quality.

### BACKGROUND OF THE INVENTION

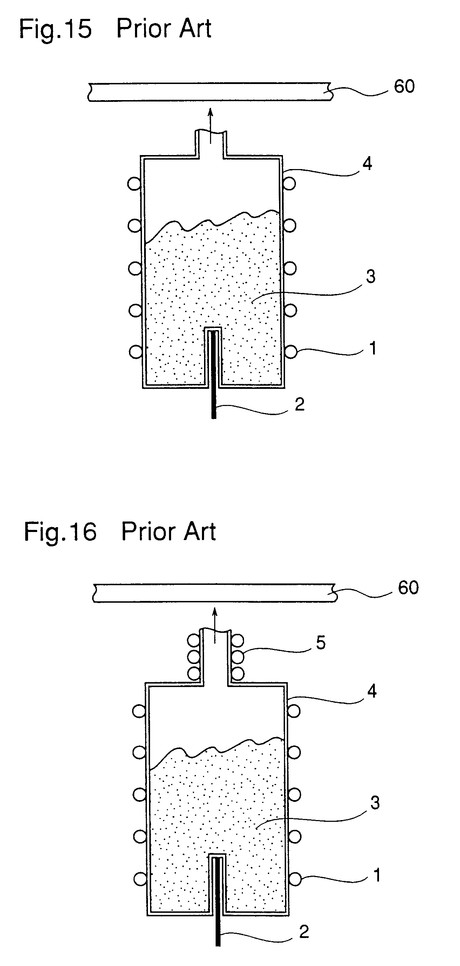

Conventionally, when GaAs was grown by MBE, metal Ga is used as III group raw material and metal As is used as V group raw material. A container as illustrated in figure 15 is used for supply of a III group and a V group raw materials, and molecular beam is emitted by heating. Otherwise, molecular beam is emitted in the container as illustrated in figure 16 by heating the container and heating its outlet line.

In these figures, reference numeral 4 designates a crucible, numeral 1 designates a heater provided around the crucible 4, numeral 2 designates a thermoelement for measuring the temperature of the crucible 4, numeral 3 designates a metal As block contained in the crucible 4, and numeral 5 designates a heater provided along the outlet line. The above-described crucible 4 is made of high-purity PBN (Pyrolytic Boron Nitride). Reference numeral 60 designates a substrate.

When the above-described crucible 4 is heated in a vacuum, the molecular beam corresponding to the saturated vapor pressure in the crucible 4 is obtained. At this time, in order to obtain a stable beam amount, it is necessary to perform the temperature control in a range of about ±0.1 ∼ ±1 and make the saturated vapor pressure stable. In addition, in order to obtain a growth rate of about 1 µm/hr, it is required that solid As is heated to the temperature of about 200 °C ∼ 300 °C. The construction in which the outlet line is heated as in figure 16, is useful to make As₄ that is generated by heating the metal As decompose into As₂, which has a higher growth efficiency than As₄.

In the crystal growth in which an MBE apparatus is used, due to heat treatment in a high vacuum, the average free distance of molecules strikingly becomes longer. Therefore, As molecules reach directly the surface of the substrate 60 in the growth chamber, and then, after the migration on the surface of the substrate 60, the molecules go into lattice positions and are combined with III group elements. The greatest characteristic in this growth process is that since the III group and V group atoms are combined without causing a chemical reaction in the vicinity of the substrate 60, the controllability of film thickness at the interface is improved, whereby thickness control in the sub-nanometer order can be performed even at a high growth speed. In addition, an MBE apparatus has been already used for mass production of electronic devices, and it is reported that the crystal growth of many devices can be performed with stability at low cost.

By the way, when the crystal growth is continued using the above-described apparatus, the intensity of the molecular beam is lowered according to the evaporation of the metal As block 3 in the crucible 4. As a result, the ratio of V group to III group is lowered in the same growth rate when the crystal is grown, whereby it is difficult to form a desired layer structure.

In order to compensate for the defect, gaseous V group material may be used in place of the metal V group material. In this method, since the hydrogen radicals which are generated by cracking the V group material gas have reducibility and serve as a surfactant (reference 1 : Y. J. Chun, Y. Okada and M. Kawabe, Jpn. J. Appl. Phys. 32(1993)L1085; reference 2 : A. Sakai and T. Tatsumi, Appl. Phys. Lett. 64(1994)52), it is proved that mixing of oxygen is controlled and unevenness of the substrate surface is suppressed when a material which lattice mismatches with the substrate is grown.

The prior art MBE apparatus and MBE method are constituted as described above, and the grown surface of the GaAs layer has defects of at least more than 10/cm² and includes impurities represented by oxygen, whereby Ga₂O₃, As₂O₃ are generated and this portion becomes electrically inactive. Therefore, it is difficult to apply this apparatus to the fabrication of high performance devices, such as MMIC or the like, from the view of stability and reliability.

Japanese Published Patent Application No. Hei. 5-335238 discloses a method in which hydrogen is introduced during the MBE growth. In this reference, a capillary for introducing hydrogen is provided in parallel with a molecular beam source at a wall of growth chamber. Hydrogen molecules are decomposed into atoms by heated with heaters provided at the capillary for introducing hydrogen, and the decomposed hydrogen atoms are irradiated to an Si substrate so that dangling bonds at the crystal interface are terminated by hydrogen, whereby the steepness of heterojunction interface is enhanced. Therefore, it can be thought that reduction of defects at the crystal surface by suppressing absorption of oxygen during the crystal growth with using this construction is possible. However, when considering the above-described generation of oxygen which is impurity, it is thought that the oxygen is mainly included in a block of raw material and it is taken into the crystal. Therefore, since in the disclosed construction the absorption of oxygen is suppressed in the vicinity of the substrate, a high suppressing effect cannot be expected and the defects on the surface of the substrate cannot be sufficiently reduced.

Further, when gaseous As (AsH₃) is used in place of the metal As block in order to make the growth rate stable, due to that the toxicity of the As gas is extremely high, the handling during works, such as the exchange and the maintenance, is dangerous.

### SUMMARY OF THE INVENTION

It is an object of the present invention to provide MBE apparatus and MBE method in which absorption of oxygen is sufficiently suppressed.

It is another object of the present invention to provide MBE apparatus and MBE method in which a substrate before crystal growth is performed thereon can be etched.

It is another object of the present invention to provide MBE apparatus having a stable crystal rate and an easy handling of crystal material.

Other objects and advantages of the present invention will become apparent from the detailed description given hereinafter; it should be understood, however, that the detailed description and specific embodiment are given by way of illustration only, since various changes and modifications in the scope of the invention will become apparent to those skilled in the art from this detailed description.

According to a first aspect of the present invention, an MBE apparatus includes a heatable crucible containing crystal material which becomes a molecular beam state by heating, a different kind of gas introducing capillary for introducing different kind of gas other than material gas for the crystal growth into the crucible, and a crystal growth chamber in which the crystal growth is performed because the crystal material in a molecular beam state emitted from the crucible is irradiated to a substrate. Therefore, the different kind of gas is introduced into the crucible.

According to a second aspect of the present invention, in the above-described MBE apparatus, since the different kind of gas introducing capillary is one introducing gas which has reducibility into the crucible, impurities of oxidized nature, i.e., oxygen or the like, in the crystal material in the molecular beam state emitted in the crucible are collected by the gas. Therefore, the irradiated molecular beam during the crystal growth in the crystal growth chamber can be made not including impurities, whereby crystal defects on the substrate surface are significantly reduced.

According to a third aspect of the present invention, in the above-described MBE apparatus, since the gas having reducibility is hydrogen, impurities of oxidized nature, i.e., oxygen or the like, in the crystal material in the molecular beam state emitted in the crucible are collected by hydrogen. Therefore, the irradiated molecular beam during the crystal growth in the crystal growth chamber can be made not including impurities, whereby the crystal defects on the substrate surface are significantly reduced.

According to a fourth aspect of the present invention, in the above-described MBE apparatus, since the different kind of gas introducing capillary is one introducing gas which has an etching function on the crystal material into the crucible. Therefore, the amount of molecular beam of the crystal material emitted in the crucible can be controlled by the gas, whereby the composition ratio of the crystal which is grown in the crystal growth chamber can steeply change.

According to a fifth aspect of the present invention, in the above-described MBE apparatus, there are provided a different kind of gas source container which contains di-iodomethane, and a flow controller for controlling the flow rate of the di-iodomethane vapor at upstream portions of the different kind of gas introducing capillary, and the gas having an etching function to the crystal material includes iodine radical I*. Therefore, the amount of molecular beam of the crystal material emitted from the crucible can be controlled by the iodine radical I*, whereby the composition ratio of the crystal which is grown in the crystal growth chamber can steeply change.

According to a sixth aspect of the present invention, in the above-described MBE apparatus, heating means for heating the different kind of gas introducing capillary are provided at the vicinity of the connection point of the different kind of gas introducing capillary with the crucible. Therefore, the different kind of gas (the gas having reducibility, or the gas having an etching function to the crystal material) is introduced after it is heated, whereby activity of the different kind of gas is increased.

According to a seventh aspect of the present invention, in the above-described MBE apparatus, a molecule collision multiplying portion where the collision frequency of the molecule in the introduced different kind of gas is multiplied is provided in the crucible, which is communicated with the different kind of gas introducing capillary. Therefore, the introduced different kind of gas (the gas having reducibility, or the gas having an etching function on the crystal material) collides with the molecule collision multiplying portion, whereby generation of radicals of the different kind of gas is promoted.

According to an eighth aspect of the present invention, in the above-described MBE apparatus, heating means for heating the molecular beam emitted from the crucible are provided at the vicinity of an outlet for the molecular beam in the crucible. Therefore, the lifetime of the generated radicals is lengthened.

According to a ninth aspect of the present invention, in the MBE method, the crucible is heated with introducing the gas having reducibility into the crucible containing the crystal material through the different kind of gas introducing capillary, and the crystal growth is performed because the molecular beam of the crystal material is irradiated to the substrate in the crystal growth chamber with collecting the impurities of oxidized nature, i.e., oxygen or the like, in the crystal growth material in molecular beam state in the crucible by the gas. Therefore, the crystal defects on the substrate surface caused by the impurities of oxidized nature are significantly reduced.

According to a tenth aspect of the present invention, in the above-described MBE method, hydrogen is used as the gas which has reducibility and is introduced into the crucible through the different kind of gas introducing capillary. Therefore, the crystal growth is performed by that the molecular beam of the crystal material is irradiated to the substrate in the crystal growth chamber with the impurities of oxidized nature, i.e., oxygen or the like, in the crystal growth material being collected in a molecular beam state due to the hydrogen in the crucible, whereby the crystal defects caused by the impurities of oxidized nature on the substrate surface are significantly reduced.

According to an eleventh aspect of the present invention, in an MBE method, while the gas having an etching function on the crystal growth material in the crucible is introduced through the different kind of gas introducing capillary, the crucible containing the crystal material which becomes the molecular beam state by heating is heated, and the molecular beam is irradiated to the substrate in the crystal growth chamber with controlling the amount of the molecular beam emitted from the crucible by changing the supply amount of the gas into the crucible, whereby the crystal growth is performed. Therefore, the composition ratio of the crystal grown on the substrate steeply changes.

According to a twelfth aspect of the present invention, in the above-described MBE method, performing crystal growth with controlling the amount of the molecular beam emitted from the crucible is etching the substrate in the crystal growth chamber by the molecular beam of the etching gas which is generated with the gas having the etching function excessively supplied into the crucible. Therefore, the entire substrate is cleaned before the crystal growth proceeds in the crystal growth apparatus.

According to a thirteenth aspect of the present invention, in the above-described MBE method, the different kind of gas source container for containing the di-iodomethane, and the flow controller for controlling the flow rate of the di-iodomethane vapor are provided at upstream portions of the different kind of gas introducing capillary. The gas having an etching function is supplied as a gas including the iodine radical I* from the container and the flow controller. Therefore, the supply amount of the gas including the iodine radical I* is varied, so that the amount of the molecular beam of the crystal material emitted from the crucible is controlled, which is irradiated to the substrate in the crystal growth chamber, whereby the crystal growth is performed, thereby the composition ratio of the crystal is steeply varied. In addition, the molecular beam of the gas including the iodine radical I* is generated by supplying the gas excessively, whereby the entire surface of the substrate before the crystal growth is cleaned by the gas in the crystal growth apparatus.

According to a fourteenth aspect of the present invention, in the above-described MBE method, there are included a cracking chamber in which the crystal growth material of the molecular beam state emitted from the crucible is decomposed by heating, a carrier gas introducing capillary provided downstream of the crucible, and a radical generating chamber provided upstream of the carrier gas introducing capillary, in which chamber the carrier gas is decomposed to generate radicals.

According to a fifteenth aspect of the present invention, in the above-described MBE method, the crucible is disposed on the outside of the crystal growth chamber, the cracking chamber is disposed on the inside of the crystal growth chamber, and heating means for heating the line between the cracking chamber and the crucible are provided.

According to a sixteenth aspect of the present invention, in the above-described MBE method, the end of the carrier gas introducing capillary is introduced into the cracking chamber, the radical generating chamber is disposed in the cracking chamber, and the end of the carrier gas introducing capillary is connected to the radical generating chamber in the cracking chamber.

According to a seventeenth aspect of the present invention, in the above-described MBE method, a chamber for irradiating the carrier gas with ultraviolet rays and promoting generation of radicals of the carrier gas is provided between the carrier gas introducing capillary and the radical generating chamber.

According to an eighteenth aspect of the present invention, in the above-described MBE method, the radical generating chamber has a cylindric portion including a heater for heating and a cylindric portion not including the heater, and these cylindric portions are switched to connect to the outlet of the cracking chamber.

According to a nineteenth aspect of the present invention, in the above-described MBE method, there is included a structure in which the crystal material can be recruited into the crucible without exposing the inside of the crucible to the atmosphere.

According to a twentieth aspect of the present invention, in the above-described MBE method, the material recruiting structure comprises a crystal material introducing capillary provided at a side surface of the crucible, a gate valve for controlling the opening and closing state of the capillary, a loading chamber which is connected to the gate valve and which can include the crystal material within, and a structure for changing the degree of vacuum in the inside of the loading chamber.

According to a twenty-first aspect of the present invention, in the above-described MBE method, the loading chamber that can include a plurality of cartridge cases which are attached to the crystal material having a spiral groove around, and the crystal material which is attached to the cartridge case is turned using a slide rod to push out of the cartridge case, thereby discharging into the crystal material introducing capillary.

### BRIEF DESCRIPTION OF DRAWINGS

Figure 1 is a sectional view illustrating a crucible as a V group raw material supply container in the MBE apparatus according to a first embodiment of the present invention.

Figure 2 is a sectional view illustrating a crucible as a V group raw material supply container in the MBE apparatus according to a second embodiment of the present invention.

Figure 3 is a graph illustrating the relation between the amount of iodine radical I* and the crystal growth state during the crystal growth using the MBE apparatus in the second embodiment.

Figure 4 is a schematic diagram illustrating the atomic structure on the substrate during etching the substrate using the MBE apparatus in the second embodiment.

Figure 5 is a schematic diagram for explaining the case where selective growth is performed after providing a mask on the substrate surface during the crystal growth using the MBE apparatus in the first embodiment or the second embodiment.

Figure 6 is a schematic diagram for explaining the case where the selective burying growth is performed after providing a mask on the substrate surface during the crystal growth using the MBE apparatus in the first embodiment or the second embodiment.

Figure 7 is a sectional view illustrating a crucible as a V group raw material supply container in the MBE apparatus according to a third embodiment of the present invention.

Figure 8 is a sectional view illustrating a crucible as a V group raw material supply container in the MBE apparatus according to a fourth embodiment of the present invention.

Figure 9 is a sectional view illustrating a crucible as a V group raw material supply container in the MBE apparatus according to a fifth embodiment of the present invention.

Figure 10 is a sectional view illustrating a crucible as a V group raw material supply container in the MBE apparatus according to a sixth embodiment of the present invention.

Figure 11 is a sectional view illustrating a radical generating chamber as a V group raw material supply container in the MBE apparatus according to a seventh embodiment of the present invention.

Figure 12 is a sectional view illustrating a cracking chamber and a radical generating chamber as a V group raw material supply container in the MBE apparatus according to an eighth embodiment of the present invention.

Figure 13 is a sectional view illustrating a structure in which a V group raw material is recruited into a crucible as a V group raw material supply container in the MBE apparatus, according to a ninth embodiment of the present invention.

Figures 14(a)-14(d) are sectional views each illustrating a structure in which a V group raw material is recruited into a crucible as a V group raw material supply container in the MBE apparatus, according to a tenth embodiment of the present invention.

Figure 15 is a sectional view illustrating a crucible as a V group raw material supply container in the MBE apparatus according to the prior art.

Figure 16 is a sectional view illustrating a crucible as a V group raw material supply container in another MBE apparatus according to the prior art.

### DETAILED DESCRIPTION OF THE PREFERRED EMBODIMENTS

### Embodiment 1.

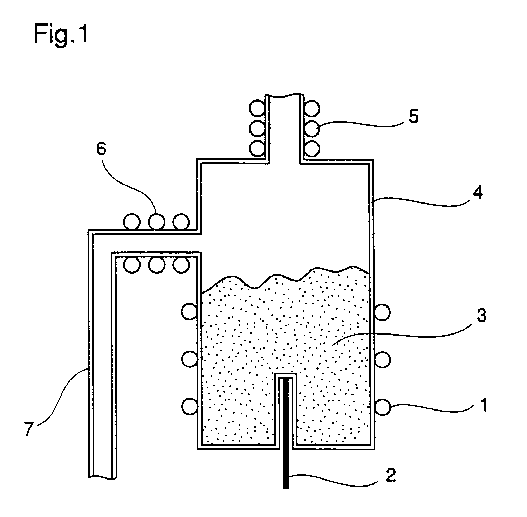

A description is given of a first embodiment of the present invention with reference to figure 1.

Figure 1 shows an MBE apparatus according to a first embodiment of the present invention. In figure 1, the same reference numerals as in figures 15 and 16 designate the same or corresponding parts. Reference numeral 7 designates a different kind of gas introducing capillary provided at a portion of a side surface of the crucible 4, and heaters 6 are provided in the vicinity of a portion of the capillary connected with the crucible 4. Assuming that hydrogen gas (H₂) is used as a different kind of gas, a metal As block 3 contained in the crucible 4 is heated at about 350°C, whereby the metal As block 3 is sublimated, so that As₄ is emitted out in a molecular beam state. On the other hand, the hydrogen introduced through the different kind of gas introducing capillary 7 is heated at about 1500°C by the heaters 6, whereby radical hydrogen H₂* is generated. Then, these As₄ and radical hydrogen H₂* are mixed in the space inside the crucible 4, and the mixture of them wafts to the vacuum system of the crystal growth chamber (not shown), therefore, when this apparatus is used together with the MBE apparatus for Ga molecular beam irradiation, a GaAs film is epitaxially grown on the substrate. Meanwhile, the radical hydrogen H₂* sensitively reacts with impurities typical of oxygen existing in the crystal growth chamber, and has a function that the absorption of the impurities into the crystals is suppressed. Especially, since the radical hydrogen H₂* can trap the oxygen or the like included in the metal As block 3 in the crucible 4 where they are generated, the radical hydrogen H₂* exhibits an effect of highly preventing from generating oxides. The radical hydrogen H₂* can also remove impurities typical of oxides at the substrate surface. The oxygen is combined with the radical hydrogen H₂* to form water molecules and to be exhausted from the crystal growth chamber without any contribution to the reaction.

As described above, in this first embodiment, a high purity GaAs layer is epitaxially grown on the substrate in the crystal growth chamber, whereby no impurities are deposited on the substrate/epitaxial layer interface. Accordingly, by that InGaAs or AlGaAs is grown on an InP substrate, defect density of less than 1/cm² can be obtained with high reproducibility and no special devises.

According to this first embodiment, the different kind of gas introducing capillary 7 is provided with the crucible 4 containing the crystal material and hydrogen is introduced into the crucible 4, so that the impurities of oxidized nature, i.e., oxygen or the like, in the crystal material are collected in the crucible where they are generated. Therefore, the crystal defects on the substrate surface in the crystal growth chamber in which the crystal growth is performed can be significantly reduced.

While hydrogen gas is introduced through the different kind of gas introducing capillary 7 in this first embodiment, other gases that have reducibility and do not adversely affect the crystal growth may be employed.

### Embodiment 2.

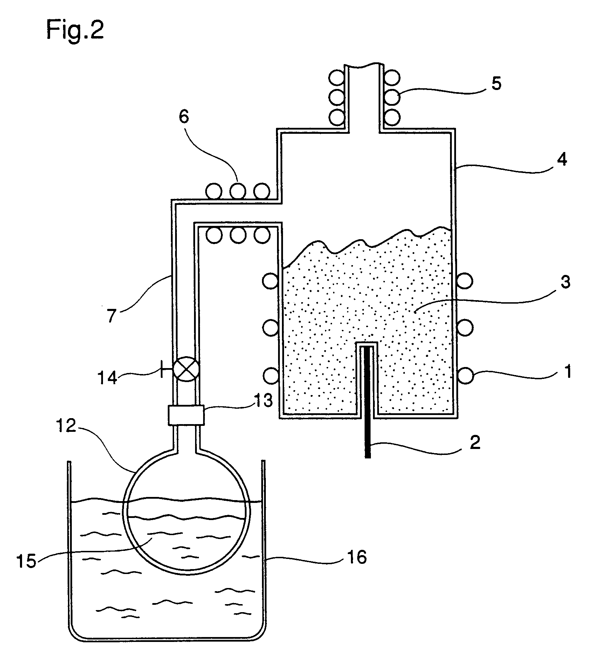

A description is given of a second embodiment of the present invention with reference to figure 2.

This embodiment is based on an assumption that di-iodomethane (CH₂I₂) is used as a different kind of gas. In figure 2, reference numeral 12 designates a container for generating a control gas including liquid CH₂I₂ (15) for controlling the amount of the molecular beam generated in the crucible 4 (Ga of a III group element), and this is connected to an upstream portion of the different kind of gas introducing capillary 7 via a gate valve 14 and a mass flow controller (MFC). Reference numeral 16 designates a constant temperature bath for keeping the temperature inside the control gas generating container 12 constant.

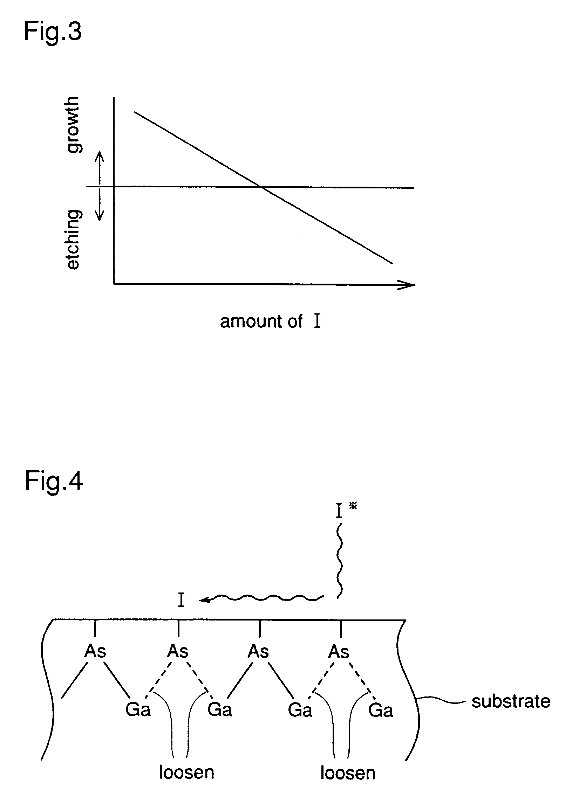

A description is given of the crystal growth process. Ga molecular beam of a quantity that is determined by the saturated vapor pressure in the crucible 4 is generated, when the gate valve 14 is closed. Next, the gate valve is opened and the electrode of the MFC 13 is adjusted, resulting in the state of figure 3, where iodine radical I* flown into the crucible 4 is increased in proportion to the increased iodomethane, and the iodine radical I* is combined with Ga, so that Ga molecular beam is decreased. The iodomethane is further increased and the iodine radical I* is increased, whereby Ga molecular beam is not generated and the iodine radical I* is irradiated toward the substrate in the crystal growth chamber in place of Ga. Hence, etching by iodide occurs on the substrate because the iodine radical I* reaches the substrate surface, thereafter it moves and is chemisorbed thereon, whereby the atomic bonds under the first layer of the substrate surface are made loose and some atoms are desorbed as shown in figure 4.

Thus, the iodine radical I* is introduced into the crucible 4 and its amount is controlled, and the amount of Ga molecular beam generated in the crucible is controlled. The amount of Ga molecular beam is controlled with high response as compared with the control dependent on the change of the temperature of the crucible 4 as in the prior art, and the composition ratio of crystal steeply changes. The entire substrate in the crystal growth chamber can be etched by the iodine radical I* before the crystal growth due to the increase in the iodine radical I* which is introduced into the crucible 4, whereby the impurities at the substrate surface are removed more effectively.

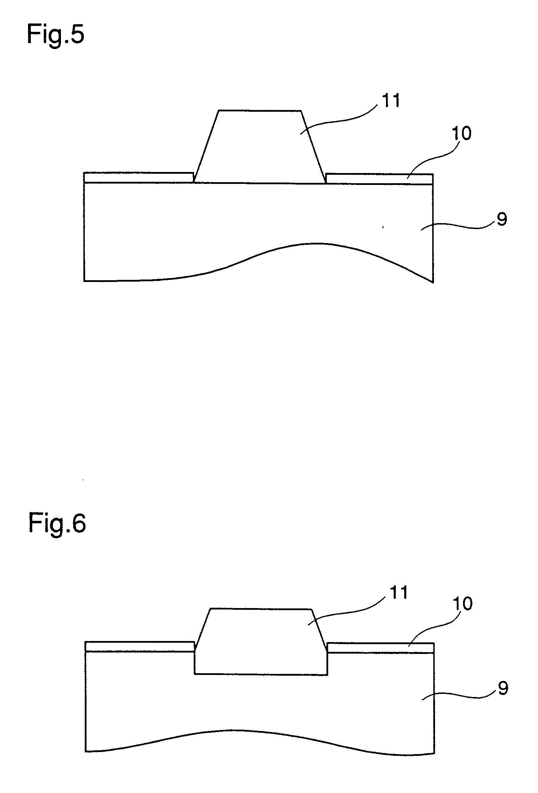

In addition, in the above-described first and second embodiments, as shown in figures 5 and 6, a pattern is previously formed on the substrate by SiO₂ film or the like, so that selective growth and selective burying growth of high purity crystals having high quality interfaces can be performed. In the figures, reference numeral 9 designates a substrate, numeral 10 designates a dielectric film, and numeral 11 designates an epitaxial growth layer.

### Embodiment 3.

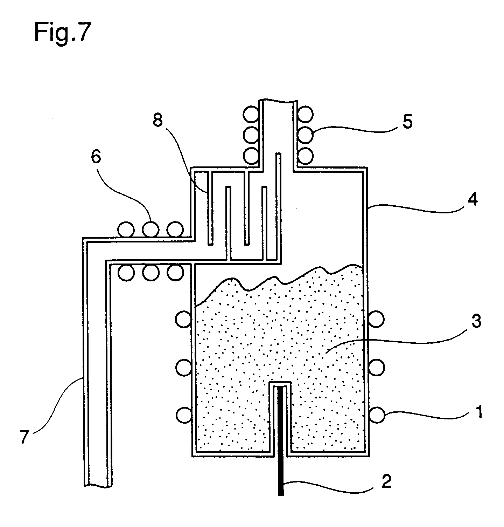

A description is given of a third embodiment of the present invention with reference to figure 7.

This third embodiment, as shown in figure 7, differs from the first embodiment of figure 1 in that the apparatus is provided with a multi-wall structure 8 which functions as a molecule collision multiplying portion for promoting the resolution of the different kind of gas which is introduced into the crucible 4.

Although the different kind of gas introduced into the crucible 4 is heated by heaters 6 provided in the vicinity of the inlet of the crucible 4, the gas is not sufficiently resolved into the radical state with only using the thermal energy in the first embodiment. To the contrary, the multi-wall structure 8 is additionally provided and the different kind of gas is made physically collided with that in this third embodiment, so that the generation of radicals is promoted.

While in the above description, the multi-wall structure 8 is provided inside the crucible 4 in the first embodiment, the multi-wall structure can be provided in the crucible 4 as in the second embodiment, so that the resolution and the generation of radical of the different kind of gas (iodine) introduced into the crucible 4 are promoted.

### Embodiment 4.

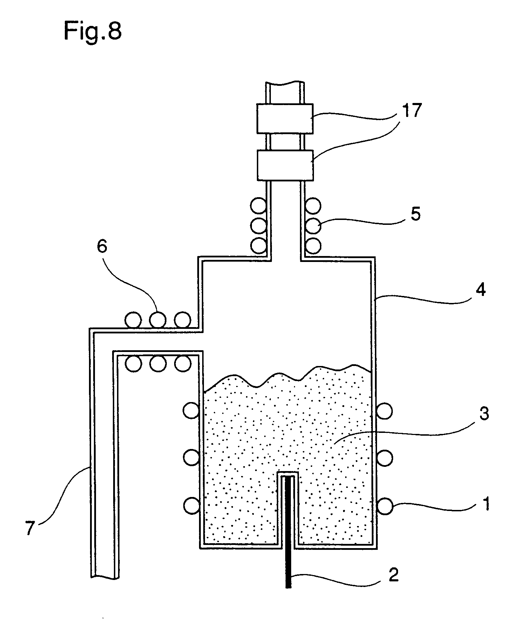

A description is given of a fourth embodiment of the present invention with reference to figure 8.

This fourth embodiment differs from the first embodiment in that the apparatus is provided with multistage heaters 17 close to the outlet for the molecular beam in the crucible 4, as shown in figure 8.

The molecular beam generated in the crucible 4 is again heated near the outlet, so that the thermal energy is given to the radicals which are offered to the crystal growth, whereby the lifetime of the radicals is lengthened.

The method of providing the multistage heaters 17 to lengthen the lifetime of the radicals is useful not only in the first embodiment, but also in the second and the third embodiments.

While Ga is used as a III group element and As is used as a V group element in the first to the fourth embodiments, other elements of the III group and V group than those may be also used.

### Embodiment 5.

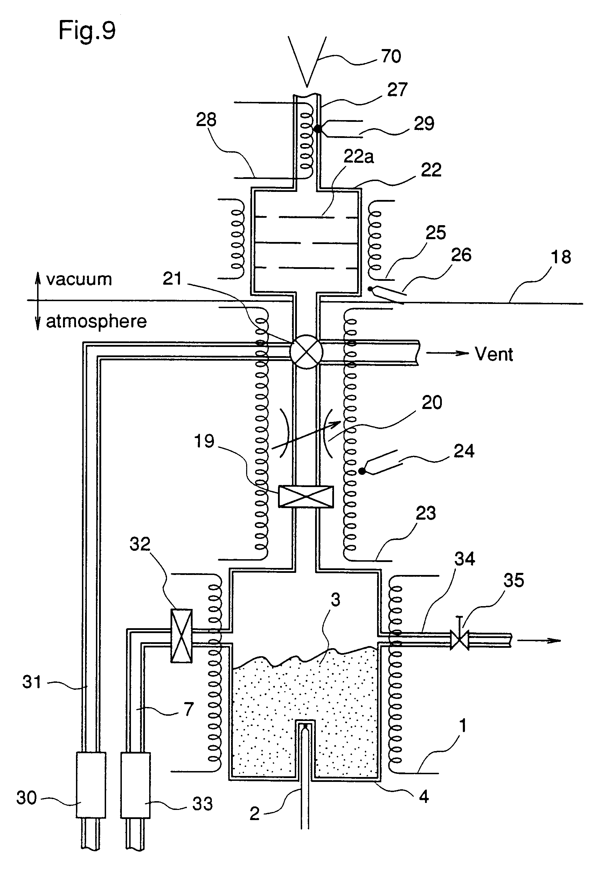

A description is given of a fifth embodiment of the present invention with reference to figure 9.

In figure 9, reference numeral 18 designates a side wall of a crystal growth chamber, and the crucible 4 in which the metal As block 3 used as a V group raw material is contained is disposed on the outside of the side wall 18 of the chamber. A gate valve 19, a control valve 20, and a switching valve 21 are successively provided at downstream portions of the outlet for the molecular beam in the crucible 4, and the outlet is connected to a cracking chamber 22 on the inside of the side wall 18 of the crystal growth chamber via the switching valve 21. Pipe heating heaters 23 are provided along the line between the crucible 4 and the cracking chamber 22, and a thermoelement 24 for controlling the temperature of the pipe heating heaters 23 is disposed by the heater 23. Heaters 25 for heating the cracking chamber 22 and a thermoelement 26 for controlling the temperature of the heaters 25 are provided around the cracking chamber 22. A heater 28 for heating the molecular beam irradiated from the cracking chamber 22 and a thermoelement 29 for controlling the temperature of the heater 28 are provided inside a radical generating chamber 27 which is connected to the outlet for the molecular beam in the cracking chamber 22.

Further, a mass flow controller 30 for introducing carrier gas is connected to the switching valve 21 via a pipe 31. When the crystals are not grown, the carrier gas flows to a vent due to the function of the switching valve 21. A mass flow controller 33 for introducing carrier gas is connected to the different kind of gas introducing capillary 7 via a gate valve 32. A pipe 34 for exchanging the atmosphere in the crucible 4 is provided at the crucible 4, and a leak valve 35 for controlling the opening and closing state of the pipe 34 is fitted to the pipe 34.

In addition, baffle plates 22a having a multi-wall structure are provided inside the cracking chamber 22. Molecular beam 70 is emitted from the radical generating chamber 27.

A description is given of the operation of the MBE apparatus during the crystal growth.

When the crystal growth is performed, the gate valves 19 and 32 are opened, the switching valve 21 is switched so that the gas from the pipe 31 is introduced into the crystal growth chamber side, and the leak valve 35 is closed. The crucible 4 is heated by the heaters 1 provided in the vicinity of the crucible 4, the carrier gas, for example, hydrogen, of which flux is controlled through the mass flow controller 33 is introduced into the crucible 4, whereby a prescribed quantity of the V group raw material, such as As₄, vaporized by the control valve 20 is obtained. Since the line between the crucible 4 and the side wall 18 of the crystal growth chamber is heated by the heaters 23, the pipes and valves are prevented from being blockaded due to that a polycrystalline layer is grown at the line. The V group gas obtained as described above is introduced into the cracking chamber 22 and is made collided with the baffle plates 22a which are heated at about 1000 °C, so that the generation of radicals is promoted.

Meanwhile, the flux of hydrogen serving as a material of radicals having reducibility is mainly controlled by the mass flow controller 30, and then, the hydrogen is supplied into the cracking chamber 22 through the pipe 31. Therefore, even when a supply amount of the V group gas is varied by the control valve 20, prescribed hydrogen radicals can be obtained. That is, a prescribed quantity of the carrier gas (hydrogen) supplied through the pipe 31 is introduced into the cracking chamber 22 and is made collided with the baffle plates 22a. However, since the temperature of the baffle plates 22a is not so high, the generation of radicals is not caused there. The radicals are generated in the radical generating chamber 27 due to the heater 28 having high temperature of about 2000 °C, and the generated radicals and the cracked V group material are emitted as the molecular beam 70.

A description is given of the operation during the exchange of the crystal growth material.

When the crystal growth materials are exchanged, the control valve 20 and the gate valves 19 and 32 are closed, and the switching valve 21 is switched to the vent side. In that state, using the leak valve 35, the inside of the crucible 4 is once evacuated. Then, the leak valve 35 is opened and the inside of the crucible 4 is exposed to the atmosphere. The crucible 4 is taken off the gate valves 19 and 32, and the crystal materials in the crucible 4 are exchanged.

As described above, according to the fifth embodiment, a solid metal As block 3 is used as the crystal material, the metal As block 3 is vaporized on the outside of the crystal growth chamber to make gaseous, and this is introduced into the chamber. Therefore, without being in danger of directly touching gaseous arsine, the safety during works, such as the maintenance, can be ensured. In addition, since molecular beam having a prescribed intensity is always supplied, the growth rate is made fixed, whereby the layer structure as intended can be easily fabricated. Further, since hydrogen gas is introduced into the crucible 4 to vaporize the metal As block 3, the impurities of oxidized nature, i.e., oxygen or the like, in the crystal material can be collected in the crucible. Furthermore, hydrogen gas is separately supplied into the crystal growth chamber to generate the radicals of the hydrogen gas, followed by emitting the molecular beam to the substrate. Therefore, the crystal defects on the substrate surface can be significantly reduced.

### Embodiment 6.

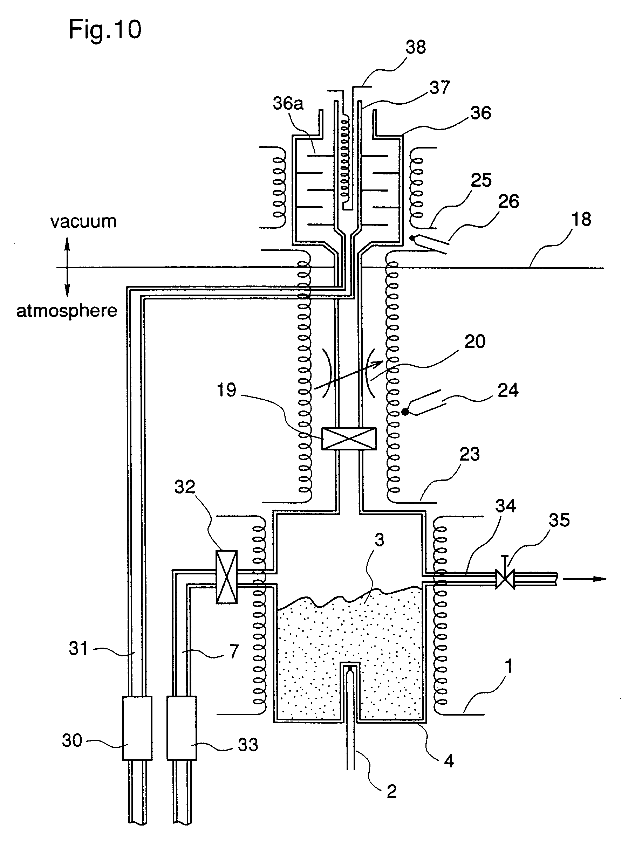

A description is given of a sixth embodiment of the present invention with reference to figure 10.

Figure 10 shows an MBE apparatus according to a sixth embodiment of the present invention. In figure 10, reference numeral 36 designates a cracking chamber including baffle plates 36a having a multi-wall structure, provided inside the cracking chamber 36. A radical generating chamber 37 is disposed in the cracking chamber 36, of which radical generating chamber one end is connected to the pipe 31 and the other end is left open in the opening portion of the cracking chamber 36. A heater 38 is provided in a portion of the radical generating chamber 37 corresponding to the inside of the cracking chamber 36 from the end portion of the radical generating chamber 37.

A description is given of the operation of the MBE apparatus according to the sixth embodiment of the invention.

When the crystal growth is performed, similarly in the fifth embodiment, the valves are controlled, and the V group raw material is vaporized to be supplied into the cracking chamber 36. However, the carrier gas (hydrogen) supplied through the pipe 31 is introduced directly into the radical generating chamber 37 which is disposed in the cracking chamber 36, and the radicals of the carrier gas are generated due to the heater 38 heated at more than 1500 °C, so that these are emitted separately from the material molecules. The V group material supplied into the cracking chamber 36 is made collided with the baffle plates 36a which are heated at more than 800 °C due to the heating by the heaters 25 and the remaining heat by the heater 38, whereby the material is cracked to be emitted.

As described above, according to the sixth embodiment, the radical generating chamber 37 is disposed in the cracking chamber 36, and the carrier gas supplied through the pipe 31 is introduced directly into the radical generating chamber 37. Therefore, the whole length of the cell can be shortened by a length of the radical generating chamber 37, resulting in a compacter device.

### Embodiment 7.

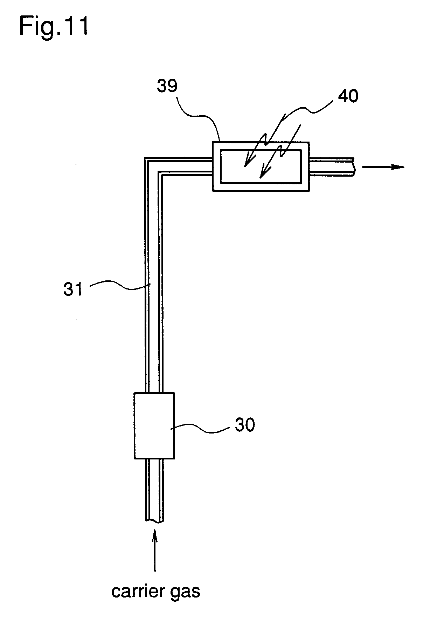

A description is given of a seventh embodiment of the present invention with reference to figure 11.

Figure 11 shows a main part of an MBE apparatus according to a seventh embodiment of the present invention. In figure 11, reference numeral 39 designates an ultraviolet rays (UV) irradiating chamber which is connected to the pipe 31, and numeral 40 designates an UV.

A description is given of the function and effect according to the seventh embodiment of the invention.

The carrier gas (hydrogen) of which flux is controlled by the mass flow controller 30 is introduced into the UV irradiating chamber 39 through the pipe 31 and is bathed in the UV 40, so that the generation of the radicals is promoted. The gas which goes out of the UV irradiating chamber 39 is supplied into the radical generating chambers 27 and 37 shown in figures 9 and 10, so that the generation of the radicals is further promoted. Consequently, since a quantity of hydrogen radical is increased, the crystal defects on the substrate surface can be further significantly reduced.

### Embodiment 8.

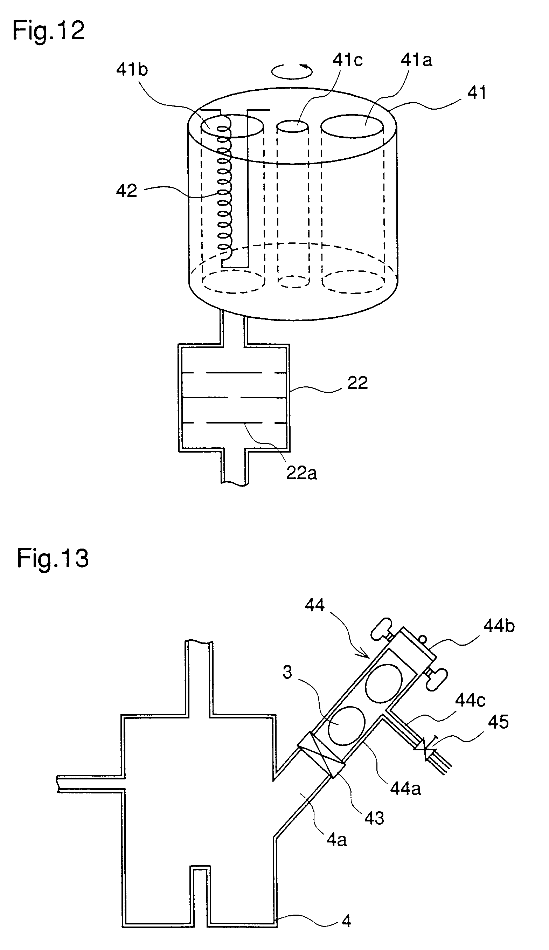

A description is given of an eighth embodiment of the present invention with reference to figure 12.

Figure 12 shows a main part of an MBE apparatus according to an eighth embodiment of the present invention. While in figures 9 and 10 the radical generating chamber is united with the cracking chamber, in this eighth embodiment the radical generating chamber and the cracking chamber are formed separately from each other, so that the switching of active/inactive at the radical generating chamber can be performed. In figure 10, a drum-shaped radical generating chamber 41 can turn on a central axis 41c, and cylindric holes 41a and 41b parallel to the central axis 41c are formed around the central axis 41c. A heater 42 is provided in the cylindric hole 41b.

A description is given of the function and effect according to the eighth embodiment of the invention.

When the crystal growth is usually performed, the cylindric hole 41b is positioned at the opening portion of the cracking chamber 22 and the carrier gas emitted from the cracking chamber 22 is heated, whereby hydrogen radical is generated. However, for example, when the generation of the hydrogen radical is impermanently stopped for such as an experiment, the drum-shaped radical generating chamber 41 is turned and the cylindric hole 41a is positioned at the opening portion of the cracking chamber 22, whereby the heating of the carrier gas is discontinued. Consequently, the on/off operation in the generation of hydrogen radical can be carried out in a moment.

### Embodiment 9.

A description is given of a ninth embodiment of the present invention with reference to figure 13.

Figure 13 shows a main part of an MBE apparatus according to a ninth embodiment of the present invention. In figure 13, reference numeral 4a designates a material introducing inlet which is projected from a portion of the crucible 4, and a material loading chamber 44 is provided at the end of the material introducing inlet 4a via a gate valve 43. This material loading chamber 44 has a loading lid 44b that can be opened and closed at the end portion of the cylindric body 44a and a pipe 44c for leaking which communicates with the inside of the body 44a at the side surface of the body 44a. A leak valve 45 is provided at the pipe 44c.

A description is given of the function and effect according to the ninth embodiment of the invention.

Since the material in the crucible 4 is decreased as the crystal growth is performed, it is required to recruit the material. Initially, the gate valve 43 is closed, and the inside of the loading chamber 44 is evacuated using the leak valve 45. After the degree of vacuum in the inside of the loading chamber 44 is made equal to that in the inside of the crucible 4, the gate valve 43 is opened, and the material 3 in the loading chamber 44 is introduced into the crucible 4 through the material introducing inlet 4a. Thereafter, the gate valve 43 is closed, and the leak valve 45 is opened to make the pressure in the loading chamber 44 into atmospheric pressure. Then, the loading lid 44b is opened and new material is recruited into the loading chamber 44, thereby preparing for the next material recruitment.

Consequently, without taking off the crucible itself and exposing the inside of the crucible 4 to the atmosphere, the material is recruited into the crucible 4, whereby the pollution of the crucible 4 due to the atmosphere can be prevented.

### Embodiment 10.

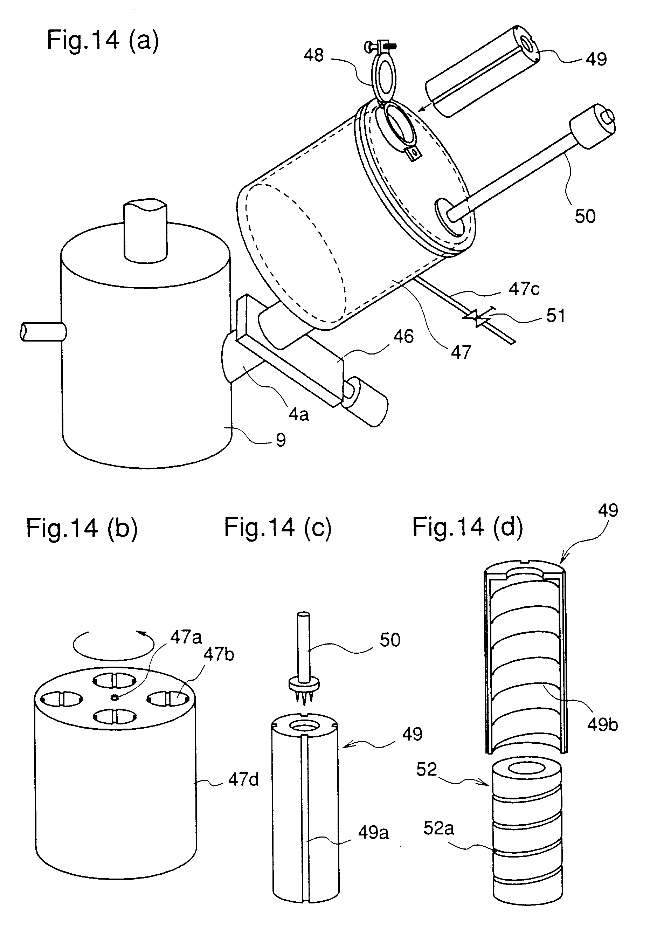

A description is given of a tenth embodiment of the present invention with reference to figures 14(a)-14(d).

Figures 14(a)-14(d) show main parts of an MBE apparatus according to a tenth embodiment of the present invention. In figures 14(a)-14(d), reference numeral 46 designates a gate valve which is fitted to the end of the material introducing inlet 4a. A cylindric load lock chamber, i.e., a revolver load lock chamber, 47 has a cylindric inner revolver 47d inside, and an axis of rotation 47a of the inner revolver 47d is surrounded with a plurality of cylindric holes 47b in which cartridge cases 49 are put, provided in parallel with the axis 47a. An opening window 48 covers above the cylindric holes 47b. A slide rod 50 is attached to ingots 52 in the inner revolver 47d and turns the ingots 52 in the cartridge cases 49. A pipe 47c is fitted to the side surface of the revolver load lock chamber 47, and a leak valve 51 for evacuating the inside of the revolver load lock chamber 47 is provided at the end of the pipe 47c.

Grooves 49a are formed around each cartridge case 49, and gibbous portions corresponding to the grooves 49a and formed on the inner surface of each cylindric hole 47b of the inner revolver 47d are attached to the grooves 49a, whereby the turn of the cartridge case itself is prevented. In addition, since a spiral groove 49b is formed on the inner surface of the cartridge case 49 and a groove 52a corresponding to the spiral groove 49b is formed on a surface of a material (ingot) 52, the material 52 is preserved in the cartridge case 49.

A description is given of the function and effect according to the tenth embodiment of the invention.

When the material 52 is recruited into the crucible 4, the material is put and preserved in each cartridge case 49 having the spiral groove 49b on the inner surface. The opening window 48 is closed and the leak valve 51 is opened. In that state, the opening window 48 is opened, and the cartridge cases 49 are put in the cylindric holes 47b. Then, the revolver load lock chamber 47 is turned, successively fitting the cartridge cases 49 to the cylindric holes 47b, followed by covering the holes 47b with the opening window 48. Thereafter, the inside of the load lock chamber 47 is evacuated using the leak valve 51, thereby reducing the pressure of the inside. After the degree of vacuum in the inside of the load lock chamber 47 is made almost equal to that in the inside of the crucible 4, the gate valve 46 is opened, and the ingot 52 in the cartridge case 49 is turned using the slide rod 50 to push out of the cartridge case 49. Then, the gate valve 46 is closed and the crystal growth is performed again. When the material in the crucible 4 is decreased again, the inner revolver 47d is turned and the same process is carried out, thereby recruiting the material into the crucible 4.

Then, when the process for recruiting the material is repeated and the material in the load lock chamber 47 is used up, the gate valve 46 is closed, the leak valve 51 is opened, the pressure in the load lock chamber 47 is made into atmospheric pressure, the opening window 48 is opened to take out the cartridge cases 49, the cartridge cases 49 to which the material 52 is attached are again put in the cylindric holes 47b, and the opening window 48 is closed. Then, the gate valve 46 is closed, the pressure in the load lock chamber 47 is reduced using the leak valve 51, thereby preparing for the next material recruitment.

Consequently, without taking off the crucible itself and exposing the inside of the crucible 4 to the atmosphere, the material is recruited into the crucible 4, and further, since a plurality of cartridge cases 49 including the material 52 are provided, the material recruitment is continuously performed, whereby the operation efficiency can be improved.

## Claims

1. An MBE apparatus (Fig. 1) including:
a heatable crucible (4) containing crystal material (3) which becomes a molecular beam state by heating;
a different kind of gas introducing capillary (7) for introducing a different kind of gas other than material gas for crystal growth into the crucible (4); and
a crystal growth chamber in which the crystal material (3) in the molecular beam state emitted from the crucible (4) is irradiated to a substrate thereby to perform a crystal growth.

2. The MBE apparatus of claim 1 wherein said different kind of gas introducing capillary (7) is one introducing gas which has reducibility into the crucible (4).

3. The MBE apparatus of claim 2 wherein the gas having reducibility is hydrogen.

4. The MBE apparatus of claim 1 wherein said different kind of gas introducing capillary (7) is one introducing gas which has an etching function on the crystal material (3) into the crucible (4).

5. The MBE apparatus of claim 4 (Fig. 2) wherein there are provided a different kind of gas source container (12) for containing di-iodomethane and a flow controller (13) for controlling flow rate of the di-iodomethane vapor at upstream portions of said different kind of gas introducing capillary (7), and the gas having an etching function to the crystal material (3) includes iodine radical I*.

6. The MBE apparatus of claim 2 including heating means for heating said different kind of gas introducing capillary (7), which are provided at the vicinity of the connection point of said different kind of gas introducing capillary (7) with said crucible (4).

7. The MBE apparatus of claim 4 including heating means for heating said different kind of gas introducing capillary (7), which are provided at the vicinity of the connection point of said different kind of gas introducing capillary (7) with said crucible (4).

8. The MBE apparatus of claim 2 (Fig. 7) further including a molecule collision multiplying portion (8) where the collision frequency of the molecule in the introduced different kind of gas is multiplied, which is provided in said crucible (4) so as to communicate with the different kind of gas introducing capillary (7).

9. The MBE apparatus of claim 4 (Fig. 7) further including a molecule collision multiplying portion (8) where the collision frequency of the molecule in the introduced different kind of gas is multiplied, which is provided in said crucible (4) so as to communicate with the different kind of gas introducing capillary (7).

10. The MBE apparatus of claim 2 (Fig. 8) further including heating means (17) for heating the molecular beam emitted from said crucible (4), which are provided at the vicinity of an outlet for the molecular beam in said crucible (4).

11. The MBE apparatus of claim 4 (Fig. 8) further including heating means (17) for heating the molecular beam emitted from said crucible (4), which are provided at the vicinity of an outlet for the molecular beam in said crucible (4).

12. An MBE method comprising:
heating a crucible (4) containing the material (3) which becomes the molecular beam state by heating while the gas having reducibility is introduced into the crucible (4) through the different kind of gas introducing capillary (7); and
irradiating the molecular beam of the crystal material (3) to the substrate in the crystal growth chamber while the impurities of oxidized nature in the crystal growth material (3) in the molecular beam state in the crucible (4) are collected by said gas.

13. The MBE method of claim 12 wherein hydrogen is used as the gas which has reducibility and is introduced into said crucible (4) through said different kind of gas introducing capillary (7).

14. An MBE method comprising:
heating the crucible (4) containing the material (3) which becomes the molecular beam state by heating with introducing the gas having an etching function on said crystal growth material (3) in the crucible (4) through said different kind of gas introducing capillary (7); and
irradiating the molecular beam to the substrate in the crystal growth chamber with controlling the amount of the molecular beam emitted from the crucible (4) by changing the supply amount of said gas having an etching function on said crystal growth material (3) into the crucible (4).

15. The MBE method of claim 14 wherein performing crystal growth while the amount of the molecular beam emitted from the crucible (4) is controlled, is etching the substrate in the crystal growth chamber by the molecular beam of the etching gas which is generated with the gas having said etching function excessively supplied into said crucible (4).

16. The MBE method of claim 14 wherein a container (12) for di-iodomethane, which is the different kind of gas source, and a flow controller (13) for controlling the flow rate of the di-iodomethane vapor are provided at upstream portions of said different kind of gas introducing capillary (7), and said gas having an etching function is supplied as a gas including the iodine radical I* from said container (12) and said flow controller (13).

17. The MBE method of claim 15 wherein a container (12) for di-iodomethane, which is the different kind of gas source, and a flow controller (13) for controlling the flow rate of the di-iodomethane vapor are provided at upstream portions of said different kind of gas introducing capillary (7), and said gas having an etching function is supplied as a gas including the iodine radical I* from said container (12) and said flow controller (13).

18. The MBE apparatus of claim 1 (Fig. 9) including a cracking chamber (22) in which the crystal growth material (3) of the molecular beam state emitted from said crucible (4) is decomposed by heating, a carrier gas introducing capillary (31) provided downstream of the crucible (4), and a radical generating chamber (27) provided upstream of the carrier gas introducing capillary (31), in which chamber (27) the carrier gas is decomposed to generate radicals.

19. The MBE apparatus of claim 18 wherein said crucible (4) is disposed on the outside of said crystal growth chamber, said cracking chamber (22) is disposed on the inside of the crystal growth chamber, and heating means for heating the line between the cracking chamber (22) and the crucible (4) are provided.

20. The MBE apparatus of claim 18 (Fig. 10) wherein the end of said carrier gas introducing capillary (31) is introduced into said cracking chamber (36), said radical generating chamber (37) is disposed in the cracking chamber (36), and the end of the carrier gas introducing capillary (31) is connected to the radical generating chamber (37) in the cracking chamber (36).

21. The MBE apparatus of claim 18 (Fig. 11) wherein a chamber (39) for irradiating the carrier gas with ultraviolet rays (40) and promoting generation of radicals of the carrier gas is provided between said carrier gas introducing capillary (31) and said radical generating chamber (27).

22. The MBE apparatus of claim 18 (Fig. 12) wherein said radical generating chamber (41) has a cylindric portion (41b) including a heater (42) for heating and a cylindric portion (41a) not including the heater (42), and these cylindric portions (41a,41b) are switched to connect to the outlet of said cracking chamber (22).

23. The MBE apparatus of claim 1 including a structure in which the crystal material (3) can be recruited into said crucible (4) without exposing the inside of the crucible (4) to the atmosphere.

24. The MBE apparatus of claim 14 including a structure in which the crystal material (3) can be recruited into said crucible (4) without exposing the inside of the crucible (4) to the atmosphere.

25. The MBE apparatus of claim 23 (Fig. 13) wherein said material recruiting structure comprises a crystal material introducing capillary (4a) provided at a side surface of said crucible (4), a gate valve (43) for controlling the opening and closing state of the capillary (4a), a loading chamber (44) which is connected to the gate valve (43) and which can include the crystal material (3) within, and a structure for changing the degree of vacuum in the inside of the loading chamber (44).

26. The MBE apparatus of claim 24 (Fig. 13) wherein said material recruiting structure comprises a crystal material introducing capillary (4a) provided at a side surface of said crucible (4), a gate valve (43) for controlling the opening and closing state of the capillary (4a), a loading chamber (44) which is connected to the gate valve (43) and which can include the crystal material (3) within, and a structure for changing the degree of vacuum in the inside of the loading chamber (44).

27. The MBE apparatus of claim 25 (Fig. 14) wherein said loading chamber (44) can include a plurality of cartridge cases (49) which are attached to the crystal material (52) having a spiral groove (49b) around, and the crystal material (52) which is attached to the cartridge case (49) is turned using a slide rod (50) to push out of the cartridge case (49), thereby discharging into said crystal material introducing capillary (4a).

28. The MBE apparatus of claim 26 (Fig. 14) wherein said loading chamber (44) can include a plurality of cartridge cases (49) which are attached to the crystal material (52) having a spiral groove (49b) around, and the crystal material (52) which is attached to the cartridge case (49) is turned using a slide rod (50) to push out of the cartridge case (49), thereby discharging into said crystal material introducing capillary (4a).
